# FASCICULE DE BREVET EUROPEEN

(11) **EP 0 878 565 B1**
(45) Date de publication et mention de la délivrance du brevet: **04.09.2002**
(21) Numéro de dépôt: 98201092.8
(22) Date de dépôt: 02.04.1998
(51) Int. Cl.: C23G 5/00, H01J 37/34

(54) **Procédé et dispositif de décapage**
Verfahren und Vorrichtung zum Ätzen
Etching process and apparatus

(30) Priorité: 10.04.1997 BE 9700329
(43) Date de publication de la demande: 18.11.1998
(73) Titulaire: RECHERCHE ET DEVELOPPEMENT DU GROUPE COCKERILL SAMBRE, en abrégé: RD-CS, 4000 Liège (BE)
(72) Inventeur: Vanden Brande, Pierre, 1040 Bruxelles (BE); Weymeersch, Alain, 1300 Wavre (BE)
(74) Mandataire: Callewaert, Jean

(56) Documents cités:
- EP-A- 0 535 568
- EP-A- 0 603 587
- US-A- 5 262 030

## Description

La présente invention est relative à un procédé continu de décapage d'au moins une des faces d'un substrat de largeur variable, formé de préférence par une bande métallique continue, telle qu'une tôle d'acier, suivant lequel on déplace ce substrat suivant une direction déterminée entre une anode, par rapport à laquelle il est polarisé négativement, et au moins un circuit magnétique disposé en regard de cette anode, avec la face à décaper orientée vers l'anode, et on crée, à proximité de cette face, un plasma dans un gaz, de manière à générer des radicaux et/ou des ions agissant sur cette dernière.

Les procédés connus présentent l'inconvénient que, si la largeur du substrat varie, le support, sur lequel ce substrat se déplace, risque de se détériorer par le décapage qui se produira également latéralement, au-delà du substrat.

Un des buts essentiels de la présente invention est de proposer un procédé permettant de remédier efficacement et d'une manière très simple à cet important problème.

A cet effet, suivant l'invention, on fait usage de moyens permettant d'adapter la largeur du champ d'action du circuit magnétique à la largeur de la zone à décaper du substrat, c'est-à-dire transversalement à la direction de déplacement de celui-ci.

Avantageusement, on fait usage d'au moins un circuit magnétique dont les dimensions, dans la direction transversale à la direction de déplacement du substrat, sont réglables en fonction de la largeur de la zone à décaper de ce demier.

Suivant une forme de réalisation particulière de l'invention, on fait usage d'au moins deux circuits magnétiques différents indépendants, isolés les uns par rapport aux autres et formant un ensemble s'étendant transversalement par rapport à la direction de déplacement du substrat, sur toute la largeur de la zone précitée à décaper, au moins un de ces circuits étant mobile dans une direction transversale du substrat en fonction de la largeur de cette zone.

L'invention concerne également un dispositif pour la mise en oeuvre du procédé suivant l'invention.

Il s'agit plus particulièrement d'un dispositif qui peut être utilisé pour le décapage de substrats formés par exemple de bandes métalliques continues de largeurs très variables ou de substrats dont la largeur varie d'un endroit à l'autre et ceci sans que le support, sur lequel ces substrats reposent, puisse être détérioré par le décapage.

Ce dispositif comprend des moyens pour déplacer le substrat suivant une direction déterminée, à travers un espace ménagé entre une anode et au moins un circuit magnétique disposé en regard de cette anode, avec la face à décaper orientée vers l'anode, et des moyens pour, d'une part, polariser le substrat négativement par rapport à l'anode lors de son passage en regard de cette dernière et, d'autre part, créer entre l'anode et la face à décaper un plasma dans un gaz, de manière à générer des radicaux et/ou des ions pouvant agir sur cette face.

Suivant l'invention, d'autres moyens sont prévus permettant d'adapter la largeur du champ d'action magnétique à celle de la zone à décaper du substrat, c'est-à-dire transversalement à la direction de déplacement de celui-ci.

Suivant une forme de réalisation avantageuse, le dispositif, suivant l'invention, comprend un support à surface cylindrique sur lequel peut reposer le substrat lors de son déplacement et qui est formé d'un tambour monté en rotation autour de son axe, au moins un circuit magnétique étant agencé à l'intérieur du tambour, en regard de l'endroit où le substrat vient en contact avec le tambour.

D'autres détails et particularités de l'invention ressortiront de la description donnée ci-après, à titre d'exemples non limitatifs, de quelques formes de réalisation particulières du procédé et du dispositif de décapage suivant l'invention. Dans cette description les chiffres de référence se rapportent aux figures annexées.

La figure 1 est une vue schématique partielle en plan d'une première forme de réalisation du dispositif de décapage suivant l'invention.

La figure 2 est une vue analogue à celle de la figure 1 de la même forme de réalisation dans une autre position.

La figure 3 est une vue schématique latérale en élévation de cette première forme de réalisation.

La figure 4 est une vue schématique en plan, semblable à celle des figures 1 et 2, d'une deuxième forme de réalisation du dispositif de décapage suivant l'invention.

La figure 5 est une même vue en plan de cette deuxième forme de réalisation dans une autre position.

La figure 6 est une vue schématique partielle en plan d'une troisième forme de réalisation du dispositif suivant l'invention.

La figure 7 est une vue schématique partielle en plan d'une quatrième forme de réalisation du dispositif suivant l'invention.

La figure 8 est une vue schématique partielle en élévation latérale de la forme de réalisation montrée à la figure 7.

La figure 9 est une vue schématique partielle en plan d'une cinquième forme de réalisation de l'invention.

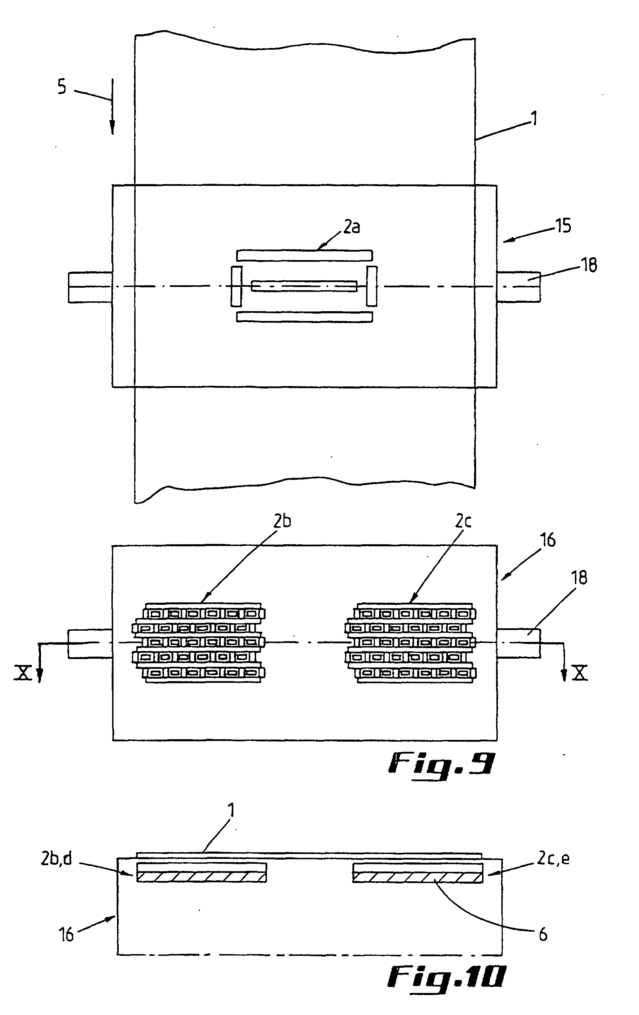

La figuré 10 est une coupe partielle suivant la ligne X-X de la figure 9.

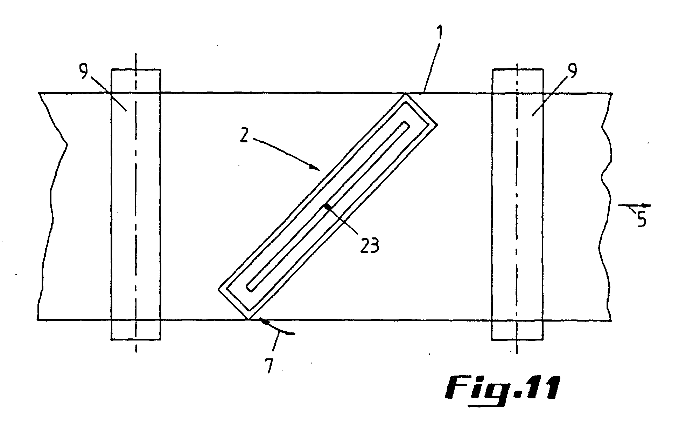

La figure 11 est une vue schématique partielle en plan d'une sixième forme de réalisation suivant l'invention.

Dans les différentes figures les mêmes chiffres de référence se rapportent à des éléments identiques ou analogues.

L'invention concerne tout d'abord un procédé continu pour le décapage d'une ou des deux faces d'un substrat formé de préférence par une bande métallique continue, telle qu'une tôle d'acier, une feuille d'aluminium, etc.

Suivant ce procédé, on déplace cette bande suivant une direction déterminée dans un espace ménagé entre une anode, par rapport à laquelle il est polarisé négativement, et au moins un circuit magnétique disposé en regard de cette anode, avec la face à décaper de la bande orientée vers l'anode, et on crée entre cette dernière et le substrat un plasma dans un gaz, tel que de l'argon ou un gaz réactif, de manière à générer des radicaux et/ou des ions pouvant agir sur la face à décaper.

Ce procédé se caractérise essentiellement par le fait que l'on fait usage de moyens permettant d'adapter, de préférence automatiquement, la largeur du champ d'action du circuit magnétique à la zone à décaper de la bande, c'est-à-dire transversalement à la direction de déplacement de celle-ci.

En fait, comme il résulte déjà de ce qui précède, l'invention vise à proposer un procédé qui permet de limiter l'action des radicaux et/ou ions générés dans le plasma sur toute la zone à décaper de la bande métallique et uniquement sur cette zone, c'est-à-dire qui ne s'étend pas latéralement par rapport à celle-ci, par exemple, sur les supports prévus dans le dispositif de décapage pour la bande. Pour obtenir ce résultat, il faut, d'une part, la présence d'une anode en regard de la surface de la zone à décaper et, d'autre part, que le circuit magnétique sous-jacent, faisant face à l'anode, constitue un circuit magnétique dont le flux agit sur toute et uniquement cette zone.

Ce procédé sera illustré davantage ci-après avec référence aux dessins annexés, qui concernent plusieurs formes de réalisation du dispositif permettant la mise en oeuvre de ce procédé.

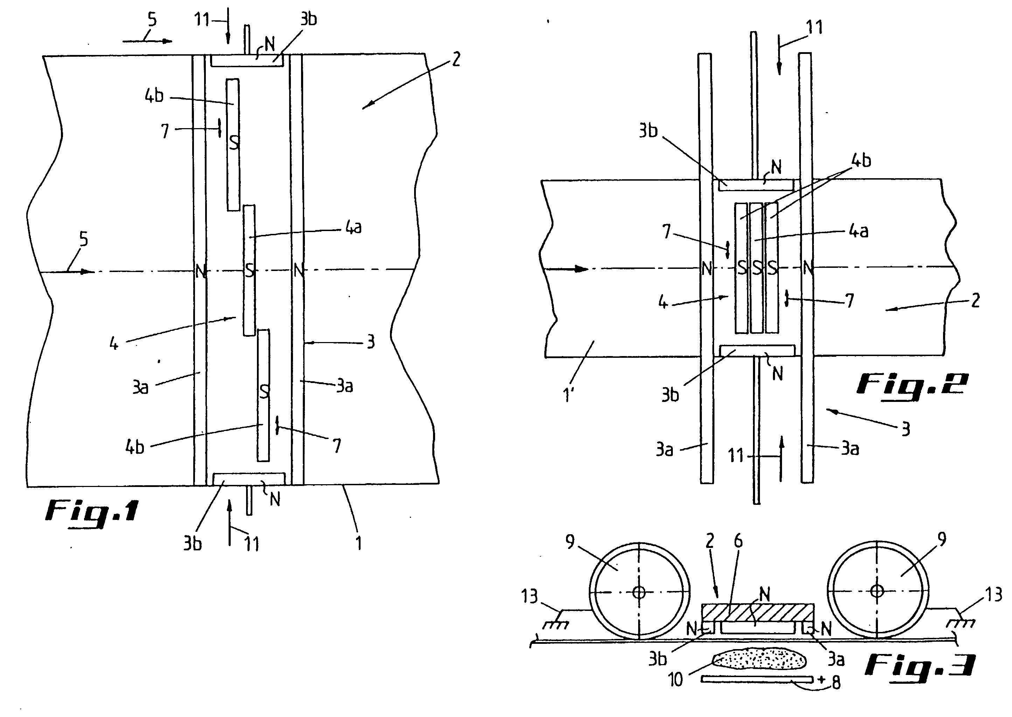

Dans la forme de réalisation illustrée par la figure 1, on montre une vue en plan d'une bande métallique formée, par exemple, par une tôle d'acier 1 présentant une largeur maximum pour ce dispositif spécifique et se déplaçant en dessous d'un circuit magnétique 2 s'étendant sur toute cette largeur, sans toutefois la dépasser.

Ce circuit magnétique 2 comprend des aimants permanents en forme d'un cadre rectangulaire 3 constituant le pôle nord à l'intérieur duquel sont agencés des aimants permanents formés de trois barreaux parallèles successifs 4 constituant le pôle sud ou inversement et s'étendant transversalement au sens de déplacement de la tôle 1, indiqué par la flèche 5.

Le barreau central 4a du pôle sud comme les côtés longitudinaux 3a du cadre 3, formant le pôle nord, sont fixes et sont montés sur une plaque ferromagnétique 6, comme montré à la figure 3.

Les côtés d'extrémité 3b du cadre 3, parallèles à la direction de déplacement de la tôle 1, et les barreaux 4b du pôle sud peuvent coulisser ensemble dans le sens transversal par rapport au sens de déplacement de la tôle, comme indiqué par les flèches 7. Ainsi, les barreaux 4b sont solidaires des côtés 3b du cadre 3 et peuvent coulisser par rapport à la plaque 6, par exemple dans une rainure, non représentée, pratiquée dans cette dernière.

Une anode fixe 8 est montée du côté opposé par rapport à la bande métallique 1 en regard du circuit magnétique 2. Cette anode 8 peut avantageusement s'étendre sur toute la largeur maximum admissible de la tôle et présente une largeur sensiblement égale aux côtés longitudinaux 3a du cadre 3 formant le pôle nord. Une telle anode 8 a été représentée schématiquement à la figure 3, qui est une vue latérale du dispositif montré en plan aux figures 1 et 2.

La tôle 1, qui est attirée par les aimants formant le pôle nord 3 et le pôle sud 4 du circuit magnétique 2, est tenue à une certaine distance de ces aimants par des rouleaux de guidage 9 s'étendant de part et d'autre du circuit magnétique 2.

Il a été constaté que de bons résultats ont été obtenus si cette distance est de l'ordre de 0,5 cm.

Pour polariser la tôle 1 négativement par rapport à l'anode 8 celle-ci est mise à la terre par l'intermédiaire des rouleaux 9, comme indiqué schématiquement par les références 13 sur la figure 3.

Comme déjà mentionné ci-dessus, le décapage de la face de la bande métallique 1 orientée vers l'anode 8 est obtenu en créant un plasma 10 dans l'espace ménagé entre cette dernière et la bande métallique 1, comme également montré à la figure 3. Ce plasma génère dans un gaz, tel que de l'argon, des ions qui bombardent la zone de la face à décaper de la bande 1 passant entre l'anode 8 et les aimants 3 et 4 déterminant le circuit magnétique 2.

La figure 2 est une vue analogue à la figure 1 du même dispositif, mais dans laquelle la bande métallique à décaper présente une largeur sensiblement inférieure à celle de la figure 1.

Pour que le décapage ne puisse se faire que sur la bande métallique 1, on rapproche les côtés mobiles 3b du cadre 3 formant le pôle nord, comme indiqué par les flèches 11, jusqu'à ce que ces côtés mobiles viennent se situer au-dessus des bords latéraux de la bande 1, comme illustré donc par la figure 2, étant donné que les barreaux 4b du pôle sud sont solidaires de ces côtés 3b ; ces barreaux vont donc coulisser de part et d'autre du barreau fixe 4a de ce pôle sud.

Le cas échéant, des moyens électroniques, connus en soi, pourraient être prévus pour régler automatiquement la position des parties mobiles 3b et 4b du circuit magnétique en fonction de la largeur de la bande passant entre ce circuit et l'anode 8. De tels moyens n'ont toutefois pas été représentés aux figures.

La figure 4 est une vue analogue à celle des figures 1 et 2 d'une deuxième forme de réalisation du dispositif de décapage suivant l'invention.

Cette forme de réalisation se distingue par rapport à la première forme de réalisation par le fait qu'elle comprend trois circuits magnétiques différents isolés les uns par rapport aux autres, respectivement un circuit magnétique central fixe 2a et deux circuits latéraux 2b et 2c opposés l'un à l'autre suivant l'axe de la bande métallique 1 et s'étendant jusqu'aux bords latéraux de celle-ci.

Une autre différence par rapport à la première forme de réalisation est que ces circuits magnétiques 2a, 2b, 2c ne sont pas réglables en dimensions, contrairement donc à ce qui est le cas du circuit unique 2 de cette première forme de réalisation, et que les circuits 2b et 2c sont mobiles transversalement à la direction de déplacement de la tôle 1, comme montré par les flèches 7, en fonction de la largeur de cette dernière, et ceci de préférence indépendamment l'un de l'autre:

La figure 4 montre le décapage d'une bande métallique large, les trois circuits magnétiques 2a, 2b et 2c étant, dans ce cas, en service.

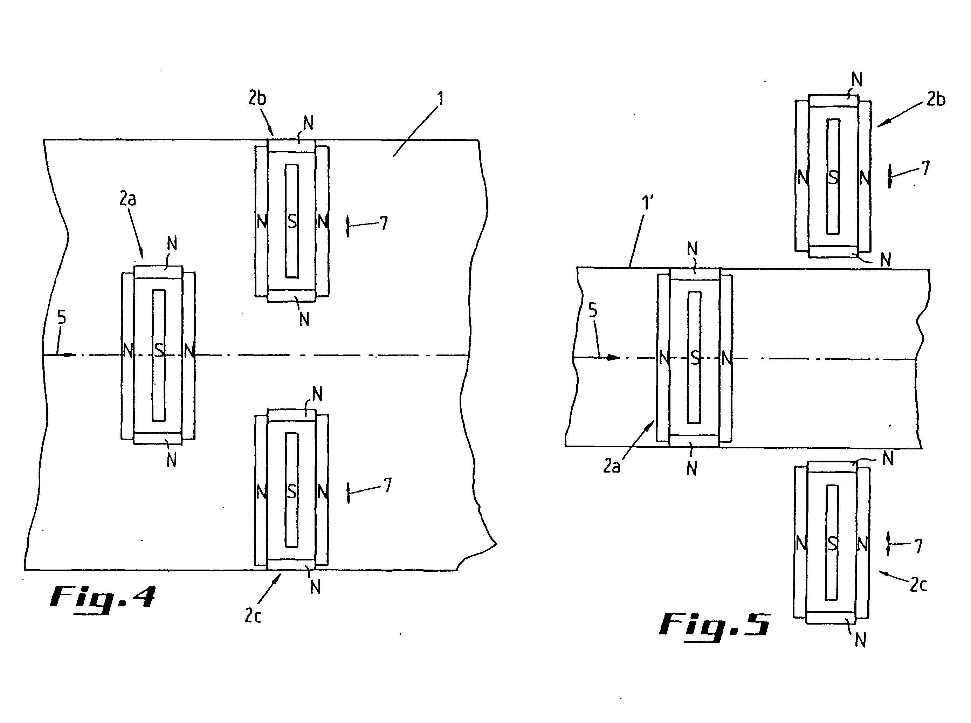

Par contre, dans la figure 5, qui concerne le traitement d'une bande métallique relativement étroite, seulement le circuit magnétique central 2a est en service.

En effet, étant donné que la bande métallique 1 ne se déplace, dans ce cas, pas en regard des circuits magnétiques latéraux 2b et 2c ceux-ci sont automatiquement mis hors service.

Si la bande métallique est plus étroite que la dimension du circuit magnétique central 2a dans le sens de la largeur de la bande 1, on peut faire usage d'un circuit magnétique de dimensions variables, comme représenté aux figures 1 et 2.

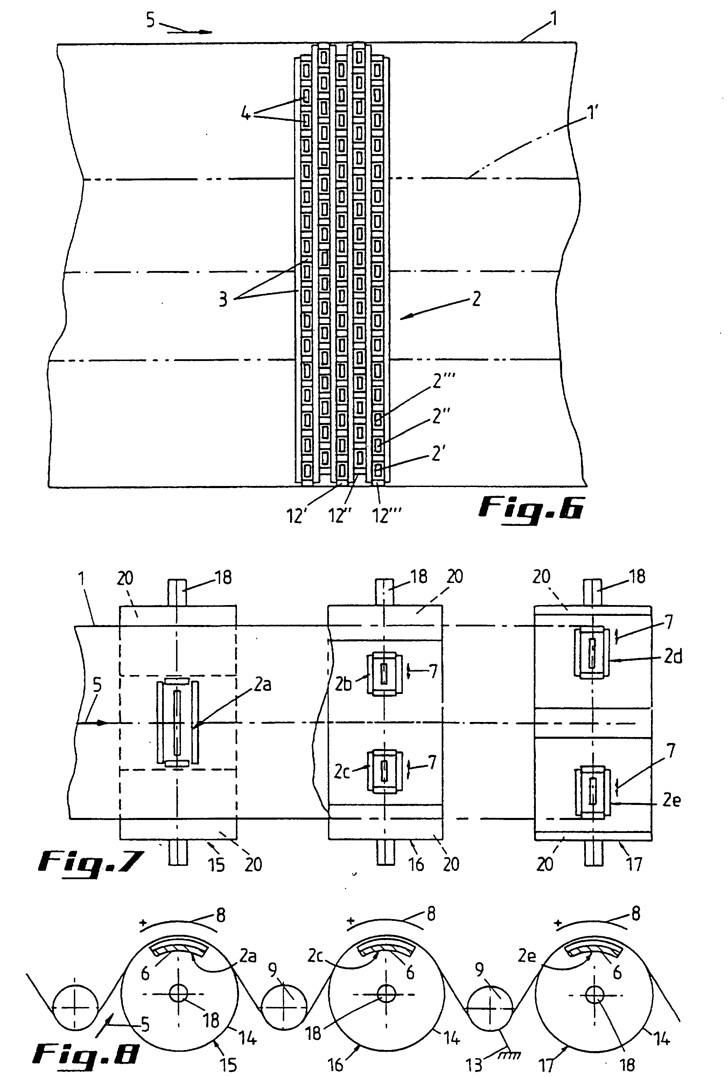

La figure 6 concerne une troisième forme de réalisation du dispositif de décapage suivant l'invention qui diffère par rapport aux précédentes formes de réalisation par le fait que le circuit magnétique 2 est constitué par une structure multicellulaire. Celle-ci est constituée d'une succession de circuits magnétiques indépendants 2', 2", 2"' etc. s'étendant les uns contre les autres en rangées successives 12', 12", 12"' etc. suivant la direction de déplacement 5 de la bande métallique 1 à décaper et ceci d'une manière telle qu'un circuit magnétique d'une rangée 12" est décalé de moitié par rapport à deux circuits magnétiques successifs 2", 2"' d'une rangée adjacente 12', 12"'.

La structure multicellulaire 2 doit, en outre, être isolée électriquement par rapport à la tôle 1.

En fait, concrètement, comme on peut le constater en considérant la figure 6, un tel circuit 2 est constitué d'une grille formant le pôle nord 3 dans les mailles de laquelle se situent des éléments formant le pôle sud 4, ou inversement.

Dans la forme de réalisation, telle que montrée à la figure 6, les mailles d'une rangée sont décalées par rapport aux mailles des rangées adjacentes d'une distance correspondant à la moitié de la longueur d'une maille, de sorte que les pôles sud d'une rangée s'étendent en regard d'une traverse du pôle nord d'une rangée adjacente.

La taille des cellules 2', 2", 2"', etc. de la structure multicellulaire précitée 2 et l'amplitude du décalage de deux rangées de cellules adjacentes 12' et 12"' dans la direction transversale de la tôle 1 permettent de déterminer la largeur de la zone de bord de la tôle qui ne sera pas traitée. En effet, il y a lieu de noter qu'une cellule qui ne s'étend pas entièrement en regard de la tôle ne fonctionnera pas. Ceci est donc généralement le cas pour la zone de bord de la tôle. Ainsi, lorsque les cellules magnétiques 2', 2" et 2" sont de dimensions suffisamment réduites et que le décalage des cellules de deux rangées adjacentes est également suffisamment faible, il pourra toujours exister dans rangées pour lesquelles les cellules sont entièrement recouvertes par la tôle jusque en bord de rive. Ceci aura comme conséquence que la tôle pourra être décapée sur toute sa largeur, d'un bord de rive à l'autre.

Au plus petites que sont les cellules ainsi formées au mieux sera la précision de réglage du circuit magnétique total en fonction de la largeur de la bande métallique à décaper.

Dans un exemple spécifique du dispositif suivant l'invention, le circuit magnétique multicellulaire est constitué de quatre rangées de cellules ou circuits simples de 10 cm x 5 cm avec un décalage de 5 cm par rangée.

Ceci permet de décaper bord à bord des tôles de largeur de multiple de 5 cm. Par contre, les tôles d'une autre largeur présenteront toujours un bord de rive non traité. Par exemple, une tôle de 62 cm de largeur présentera une zone longitudinale totale de 2 cm non traitée. Cette zone peut se trouver à proximité d'un ou se répartir sur les deux bords de la tôle.

La forme de réalisation illustrée par les figures 7 et 8 se distingue essentiellement par rapport aux précédentes, par le fait que la bande métallique 1 repose sur la paroi cylindrique 14 de trois tambours successifs 15, 16 et 17, tournant chacun autour d'un axe 18, et que des circuits magnétiques 2a, 2b, 2c, 2d, 2e sont successivement agencés dans ces trois tambours 15 à 17, à une certaine distance de la paroi cylindrique 14, en regard de l'endroit où la bande métallique 1 vient en contact avec cette paroi.

Les pôles 3 et 4 de ces circuits magnétiques 2 sont montés sur des plaques ferromagnétiques 6 qui présentent le même centre de courbure que les tambours et qui sont coaxiaux avec ces derniers.

Il en est de même pour les anodes 8 qui sont agencées à l'extérieur des tambours en regard des circuits magnétiques.

La surface extérieure 19 des parois cylindriques 14 est recouverte d'une couche en une matière non conductrice, telle que du caoutchouc ou de l'alumine, lorsqu'il existe le risque qu'un circuit magnétique ne soit pas entièrement situé sous la bande métallique 1.

De part et d'autre de chaque tambour 15 à 17 sont prévus des rouleaux de renvoi 9 d'axes parallèles aux axes 18 de ces tambours permettant d'appliquer la bande métallique fermement sur une surface relativement grande du tambour dans l'espace entre les circuits magnétiques 2 et les anodes 8.

De la même façon que dans les formes de réalisation précédentes, la bande métallique 1 est mise à la terre, comme indiqué par les références 13, via les rouleaux de renvoi 9.

L'ensemble du circuit magnétique comprend, dans le tambour 15, un circuit magnétique fixe 2a et, dans les tambours 16 et 17, deux circuits magnétiques 2b et 2c respectivement 2d et 2e mobiles parallèlement aux axes 18 des tambours 16 et 17.

Ainsi, il est possible d'adapter la largeur du champ magnétique global à la largeur de la bande métallique à décaper.

Remarquons que dans la figure 7, pour la clarté de celle-ci, les rouleaux de renvoi 9 n'ont pas été représentés.

Pour éviter une flexion ou une déformation de la paroi des tambours 15, 16 et 17, surtout lorsque ceux-ci présentent une longueur relativement importante, des renforcements sont prévus à l'intérieur de ces tambours, contre leur paroi cylindrique 14.

Ces renforcements sont avantageusement formés par des cerceaux internes 20 soutenus par des rayons rigides, partant de l'axe 18 des tambours, ces rayons n'étant pas représentés aux figures.

La largeur et l'emplacement de ces cerceaux de renforcement 20 est fonction de l'endroit où se trouvent les circuits magnétiques 2a à 2e.

Ainsi, dans le tambour 15 ne contenant qu'un circuit magnétique central fixe 2a les cerceaux 20 s'étendent à partir des bords latéraux des tambours jusqu'à proximité du circuit magnétique 2a.

Dans le tambour 16, les deux cerceaux d'extrémité 20 sont plus étroits et un cerceau supplémentaire peut être prévu au centre du tambour lorsque la longueur totale des circuit magnétiques 2b et 2c est inférieure à la longueur du circuit 2a. Enfin, dans le tambour 17 les cerceaux d'extrémité 20 sont encore plus étroits, tandis que le cerceau central 20' présente une plus grande largeur.

Pour les tambours 16 et 17 dans lesquels les circuits magnétiques 2b à 2e sont mobiles parallèlement à l'axe 18, il faut, en effet, que la distance entre les cerceaux soit suffisamment importante pour permettre ce déplacement.

Les figures 9 et 10 concernent encore une autre forme de réalisation, qui peut être considérée comme la forme de réalisation préférentielle de l'invention.

Cette forme de réalisation se distingue par rapport à la précédente par le fait qu'elle ne comprend que deux tambours 15 et 16.

Le tambour 15 correspond sensiblement entièrement au premier tambour 15 de la précédente forme de réalisation, alors que, dans le tambour 16 de cette dernière forme de réalisation, les deux circuits magnétiques classiques 2b et 2c ont été remplacés par deux circuits multicellulaires du même type que celui représenté à la figure 6. Dans ce cas, le tambour est, en outre, revêtu d'une couche en une matière isolante de l'électricité pour empêcher la formation du plasma sur la surface cylindrique du tambour latéralement par rapport à la tôle supportée par ce dernier.

Ces circuits 2b et 2c peuvent soit être fixes, soit être mobiles suivant une direction parallèle à l'axe de rotation 18 du tambour 16.

Dans ce dernier cas, le déplacement de ces circuits peut être limité à la moitié de la dimension d'une cellule suivant cette direction pour ajuster parfaitement le décapage de la tôle d'un bord de rive à l'autre.

De plus, il faut, tant pour les circuits fixes que pour les circuits mobiles, que ces derniers chevauchent toujours avec le circuit magnétique fixe agencé dans le tambour 15, de manière à ce que le champ magnétique s'étend sur toute la largeur de la bande métallique à couvrir.

Le fait que ces circuits peuvent être fixes ou subir un déplacement relativement réduit permet d'agencer à l'intérieur du tambour 16 des renforcements, non représentés, relativement larges sans gêner ces circuits, contrairement donc à ce qui est le cas dans la précédente forme de réalisation qui nécessite généralement un tambour supplémentaire 17 pour couvrir la même largeur de décapage que celle de cette dernière forme de réalisation.

Dans une variante de cette forme de réalisation, le circuit magnétique fixe agencé dans le tambour 15 pourrait être remplacé par un circuit magnétique de dimensions variables, tel que représenté aux figures 1 et 2 de manière à permettre ainsi de traiter des bandes métalliques plus étroites encore.

Dans une autre variante encore par rapport aux formes de réalisation représentées aux figures 8 à 10 un même tambour peut contenir deux circuits magnétiques décalés radialement, c'est-à-dire suivant la direction de rotation du tambour.

Un de ces circuits peut se trouver du côté gauche l'autre du côté droit tout en étant mobiles ou non suivant une direction parallèle à l'axe du tambour.

La sixième forme de réalisation du dispositif suivant l'invention, telle que montrée à la figure 11, se distingue par rapport aux précédentes par le fait qu'elle comprend un seul circuit magnétique 2 de dimensions constantes qui est monté sur un support, non représenté, pouvant pivoter autour d'un axe vertical 23.

Ainsi, pour l'adaptation du circuit magnétique 2 à la largeur de la tôle à décaper, il suffit de faire pivoter ce circuit autour de l'axe 23.

A titre de variante, on peut remplacer ce circuit magnétique par une structure multicellulaire ou par un circuit de dimensions variables, comme illustré par certaines des formes de réalisation précédentes. Cette forme de réalisation est particulièrement avantageuse pour le traitement de bandes métalliques en une matière non ou faiblement magnétique, telle que du cuivre, de l'aluminium ou de l'acier inoxydable.

Il est bien entendu que l'invention n'est pas limitée aux différentes formes de réalisation décrites ci-dessus ou représentées dans les dessins, et que d'autres variantes encore pourraient être envisagées sans sortir du cadre de l'invention, par exemple par une combinaison de deux ou plusieurs des formes de réalisation décrites ci-dessus et/ou représentées dans les dessins annexés.

C'est ainsi que l'anode peut avoir des formes très variables et pourrait, par exemple, être constituée d'un fil. De plus, lorsque la bande à décaper couvre toute la largeur du support sur lequel elle repose ou contre lequel elle est appliquée, ce support peut être réalisé en une matière conductrice d'électricité, par exemple, en acier. Ceci peut en fait être le cas pour toutes les formes de réalisation où le support ne s'étend pas en regard d'un circuit magnétique multicellulaire comme par exemple les formes de réalisation suivant les figures 1 à 5.

Par ailleurs, ce procédé peut également s'appliquer sur des substrats formés de plaques rigides séparées pouvant se déplacer l'un après l'autre.

## Revendications

1. Procédé continu de décapage d'au moins une des faces d'un substrat (1) de largeur variable, formé de préférence d'une bande métallique continue, telle qu'une tôle d'acier, suivant lequel on déplace ce substrat (1) suivant une direction déterminée entre une anode (8), par rapport à laquelle il est polarisé négativement, et au moins un circuit magnétique (2) disposé en regard de cette anode (8), avec la face à décaper orientée vers l'anode (8), et on crée, à proximité de cette face, un plasma (10) dans un gaz, de manière à générer des radicaux et/ou des ions agissant sur cette dernière, **caractérisé en ce que** l'on fait usage de moyens permettant d'adapter la largeur du champ d'action du circuit magnétique à la largeur de la zone à décaper du substrat (1), c'est-à-dire transversalement à la direction de déplacement (5) de celui-ci.

2. Procédé suivant la revendication 1, **caractérisé en ce que** l'on fait usage d'au moins deux circuits magnétiques différents indépendants (2a, 2b, 2c, 2d, 2e), isolés les uns par rapport aux autres, formant un ensemble s'étendant transversalement par rapport à la direction de déplacement (5) du substrat (1), sur toute la largeur de la zone précitée à décaper.

3. Procédé suivant la revendication 1 ou 2, **caractérisé en ce que** l'on fait usage d'un circuit multicellulaire (2) comprenant une succession de circuits magnétiques (2', 2", 2"') de dimensions relativement réduites s'étendant les uns contre les autres en rangées successives (12', 12", 12''') transversalement à la direction de déplacement (5) du substrat (1).

4. Procédé suivant l'une quelconque des revendications 1 à 3, **caractérisé en ce que** l'on fait usage d'au moins un circuit magnétique (2b, 2c, 2d, 2e) dont les dimensions, dans la direction transversale à la direction de déplacement du substrat, sont réglables en fonction de la largeur de la zone à décaper du substrat (1).

5. Procédé suivant l'une quelconque des revendications 2 à 4, **caractérisé en ce que** l'on fait usage de circuits magnétiques (2) qui s'étendent suivant au moins deux rangées transversales (12', 12", 12"') par rapport à la direction de déplacement (5) du substrat (1), en veillant à ce que les circuits d'une des rangées (12") chevauchent avec ceux de l'autre rangée (12', 12"') en considérant la direction de déplacement (5) du substrat (1).

6. Procédé suivant la revendication 5, **caractérisé en ce que** l'on fait usage de circuits magnétiques identiques (2', 2", 2"') groupés disposés l'un contre l'autre en rangées successives (12', 12", 12"') suivant la direction de déplacement (5) du substrat (1) et en appareil régulier, d'une manière telle qu'un circuit magnétique d'une rangée (12") est décalé de moitié par rapport aux circuits magnétiques successifs d'une rangée adjacente (12', 12"') de circuits magnétiques (2', 2", 2''').

7. Dispositif pour le décapage d'au moins une des faces d'un substrat (1) de largeur variable, notamment d'une bande métallique continue, telle qu'une tôle d'acier, comprenant des moyens pour déplacer ce substrat (1) suivant une direction déterminée (5) entre une anode (8) et au moins un circuit magnétique (2) disposé en regard de cette anode (8), avec la face à décaper orientée vers l'anode (8), des moyens étant également prévus, d'une part, pour polariser le substrat négativement par rapport à l'anode (8) lors de son passage en regard de cette dernière et, d'autre part, pour créer entre l'anode (8) et la face à décaper un plasma (10) dans un gaz, de manière à générer des radicaux et/ou des ions pouvant agir sur cette dernière, **caractérisé en ce que** d'autres moyens sont prévus permettant d'adapter automatiquement la largeur du champ d'action de ce circuit magnétique à celle de la zone à décaper du substrat (1), c'est-à-dire transversalement à la direction de déplacement de celui-ci.

8. Dispositif suivant la revendication 7, **caractérisé en ce que** les autres moyens précités permettant d'adapter la largeur du champ d'action du circuit magnétique comprennent au moins deux circuits magnétiques (2a, 2b, 2c, 2d, 2e) différents indépendants, isolés les uns par rapport aux autres et formant un ensemble s'étendant transversalement par rapport à la direction de déplacement (5) du substrat (1), sur toute la largeur de la zone précitée à décaper.

9. Dispositif suivant la revendication 8, **caractérisé en ce que** chaque circuit magnétique (2) comprend un pôle sud central (4) entouré, à une certaine distance par un pôle nord (3), ou inversement, ces pôles (3, 4) étant orientés vers le substrat.

10. Dispositif suivant la revendication 8 ou 9, **caractérisé en ce qu'**il comprend au moins un circuit magnétique (2) dont les dimensions, dans la direction transversale à la direction de déplacement (5) du substrat (1), sont réglables en fonction de la largeur de la zone à décaper de ce dernier.

11. Dispositif suivant l'une quelconque des revendications 8 à 10, **caractérisé en ce qu'**il comprend un circuit magnétique central (2a) variable ou non et des circuits magnétiques latéraux mobiles ou variables (2b, 2c, 2d, 2e) suivant une direction (7) transversale à la direction de déplacement (5) du substrat (1), ces circuits magnétiques latéraux (2b, 2c, 2d, 2e) étant décalés par rapport au circuit magnétique central (2a) dans la direction de déplacement (5) du substrat (1).

12. Dispositif suivant l'une quelconque des revendications 7 à 11, **caractérisé en ce qu'**il comprend au moins un circuit multicellulaire (2) constitué essentiellement d'un ensemble de circuits magnétiques identiques séparés (2', 2", 2"') de dimensions relativement réduites situés les uns contre les autres en rangées successives (12', 12", 12"') transversalement à la direction de déplacement (5) du substrat (1), les circuits magnétiques d'une rangée (12") étant décalées par rapport à ceux des rangées adjacentes (12', 12"').

13. Dispositif suivant l'une quelconque des revendications 7 à 12, **caractérisé en ce que** le substrat (1) repose sur la surface cylindrique (14) d'au moins un tambour (15, 16, 17) monté en rotation autour de son axe (18), au moins un circuit magnétique (2) étant agencé à l'intérieur du tambour en regard de l'endroit où le substrat (1) vient en contact avec le tambour (15, 16, 17).

14. Dispositif suivant la revendication 13, **caractérisé en ce qu'**il comprend au moins deux tambours successifs (15, 16, 17) dans la direction de déplacement (5) du substrat (1), d'axes parallèles (18) s'étendant perpendiculairement à cette direction, sur lesquels se déplace le substrat et dans chacun desquels est agencé au moins un circuit magnétique (2a, 2b, 2c, 2d, 2e).

15. Dispositif suivant la revendication 13 ou 14, **caractérisé en ce qu'**il comprend de part et d'autre du tambour (15, 16, 17) un rouleau de renvoi (9) pour le substrat (1) d'axe parallèle à celui du tambour, de manière à obtenir une surface de contact (19) entre ce dernier et le substrat (1) aussi grande que possible.

16. Dispositif suivant la revendication 14 ou 15, **caractérisé en ce que** le ou les circuits magnétiques (2a) agencés dans un des tambours (15) sont décalés par rapport à celui ou ceux agencés dans l'autre tambour (16, 17), d'une manière telle que l'ensemble de ces circuits couvre sensiblement toute la largeur du substrat (1).

17. Dispositif suivant la revendication 16, **caractérisé en ce qu'**un des tambours (15) comprend un circuit magnétique central fixe (2a) dont la dimension suivant la direction de l'axe du tambour est tout au plus égale à la largeur minimum de la surface à décaper du substrat (1), l'autre tambour (16) comprenant, à proximité de chacune de ses extrémités, un circuit multicellulaire fixe (2b, 2c) ou mobile suivant la direction de l'axe (18) de cet autre tambour (16) en fonction de la largeur de la surface à décaper.

18. Dispositif suivant l'une quelconque des revendications 7 à 17, **caractérisé en ce que** le circuit magnétique (2) est monté en rotation autour d'un axe (23) s'étendant transversalement au plan suivant lequel le substrat (1) peut se déplacer en regard de ce circuit.

## Patentansprüche

1. Kontinuierliches Verfahren zum Ätzen von mindestens einer der Flächen eines Substrats (1) von variabler Breite, das vorzugsweise aus einem kontinuierlichen metallischen Band, beispielsweise Stahlblech, gebildet ist, gemäß welchem dieses Substrat (1) längs einer bestimmten Richtung zwischen einer Anode (8), bezüglich welcher es negativ polarisiert ist, und mindestens einem Magnetkreis (2), der dieser Anode (8) gegenüber angeordnet ist, bewegt wird, wobei die zu ätzende Fläche gegen die Anode (8) gerichtet ist, und in der Nähe dieser Fläche ein Plasma (10) in einem Gas derart geschaffen wird, daß Radikale und/oder Ionen erzeugt werden, die auf diese letztere einwirken, **dadurch gekennzeichnet, daß** Mittel verwendet werden, welche es erlauben, die Breite des Wirkungsbereichs des Magnetkreises an die Breite der zu ätzenden Zone des Substrats (1), d.h. quer zu der Bewegungsrichtung (5) desselben, anzupassen.

2. Verfahren nach Anspruch 2, **dadurch gekennzeichnet, daß** mindestens zwei verschiedene, unabhängige Magnetkreise (2a, 2b, 2c, 2d, 2e) verwendet werden, die in Bezug aufeinander isoliert sind und eine Gesamtheit bilden, welche sich quer zu der Bewegungsrichtung (5) des Substrats (1) über die ganze Breite der vorstehend genannten zu ätzenden Zone erstreckt.

3. Verfahren nach einem der Ansprüche 1 oder 2, **dadurch gekennzeichnet, daß** ein multizellulärer Kreis (2) verwendet wird, der eine Folge von Magnetkreisen (2', 2", 2''') von relativ geringen Abmessungen umfaßt, welche sich gegeneinander in aufeinanderfolgenden Reihen (12', 12", 12''') quer zu der Bewegungsrichtung (5) des Substrats (1) erstrecken.

4. Verfahren nach einem der Ansprüche 1 bis 3, **dadurch gekennzeichnet, daß** mindestens ein Magnetkreis (2b, 2c, 2d, 2e) verwendet wird, dessen Abmessungen in der Richtung quer zu der Bewegungsrichtung des Substrats in Abhängigkeit von der Breite der zu ätzenden Zone des Substrats (1) einstellbar sind.

5. Verfahren nach einem der Ansprüche 2 bis 4, **dadurch gekennzeichnet, daß** Magnetkreise (2) verwendet werden, die sich längs mindestens zwei quer zu der Bewegungsrichtung (5) des Substrats (1) verlaufenden Reihen (12', 12", 12''') erstrecken, wobei dafür gesorgt wird, daß die Kreise einer der Reihen (12") sich mit denen der anderen Reihe (12', 12''') unter Berücksichtigung der Bewegungsrichtung (5) des Substrats (1) überlappen.

6. Verfahren nach Anspruch 5, **dadurch gekennzeichnet, daß** identische Magnetkreise (2', 2", 2''') verwendet werden, die gegeneinander in längs der Bewegungsrichtung (5) des Substrats (1) aufeinanderfolgenden Reihen (12', 12", 12"') angeordnet und in einem regelmäßigen Verband gruppiert sind, derart, daß ein Magnetkreis einer Reihe (12") um die Hälfte im Verhältnis zu den aufeinanderfolgenden Magnetkreisen einer benachbarten Reihe (12', 12''') von Magnetkreisen (2', 2", 2''') versetzt ist.

7. Vorrichtung zum Ätzen mindestens einer der Flächen eines Substrats (1) von variabler Breite, insbesondere eines kontinuierlichen metallischen Bandes, beispielsweise eines Stahlblechs, umfassend Mittel zum Bewegen dieses Substrats (1) längs einer bestimmten Richtung (5) zwischen einer Anode (8) und mindestens einem Magnetkreis (2), der dieser Anode (8) gegenüber angeordnet ist, wobei die zu ätzende Fläche gegen die Anode (8) gerichtet ist, wobei ferner Mittel vorgesehen sind, um zum einen das Substrat bezüglich der Anode (8) während seiner Passage gegenüber dieser letzteren negativ zu polarisieren und um zum anderen zwischen der Anode (8) und der zu ätzenden Fläche ein Plasma (10) in einem Gas zu schaffen, derart, daß Radikale und/oder Ionen erzeugt werden, die auf diese letztere einwirken können, **dadurch gekennzeichnet, daß** weitere Mittel vorgesehen sind, die es erlauben, die Breite des Wirkungsbereichs dieses Magnetkreises an diejenige der zu ätzenden Zone des Substrats (1), d.h. quer zu der Bewegungsrichtung desselben, anzupassen.

8. Vorrichtung nach Anspruch 7, **dadurch gekennzeichnet, daß** die vorstehend genannten weiteren Mittel, die es erlauben, die Breite des Wirkungsberelchs des Magnetkreises anzupassen, mindestens zwei verschiedene unabhängige Magnetkreise (2a, 2b, 2c, 2d, 2e) umfassen, die in Bezug aufeinander isoliert sind und eine Gesamtheit bilden, welche sich quer zu der Bewegungsrichtung (5) des Substrats (1) über die gesamte Breite der vorstehend genannten zu ätzenden Zone erstreckt.

9. Vorrichtung nach Anspruch 8, **dadurch gekennzeichnet, daß** jeder Magnetkreis (2) einen zentralen Südpol (4) umfaßt, der in einer gewissen Entfernung von einem Nordpol (3) umgeben ist, oder umgekehrt, wobei diese Pole (3, 4) gegen das Substrat gerichtet sind.

10. Vorrichtung nach Anspruch 8 oder 9, **dadurch gekennzeichnet, daß** sie mindestens einen Magnetkreis (2) umfaßt, dessen Abmessungen in der Richtung quer zu der Bewegungsrichtung (5) des Substrats (1) in Abhängigkeit von der Breite der zu ätzenden Zone dieses letzteren einstellbar sind.

11. Vorrichtung nach einem der Ansprüche 8 bis 10, **dadurch gekennzeichnet, daß** sie einen zentralen Magnetkreis (2a), umfaßt, der variabel ist oder nicht, und seitliche Magnetkreise (2b, 2c, 2d, 2e), die längs einer Richtung (7) quer zu der Bewegungsrichtung (5) des Substrats (1) beweglich oder variabel sind, wobei diese seitlichen Magnetkreise (2b, 2c, 2d, 2e) im Verhältnis zu dem zentralen Magnetkreis (2a) in der Bewegungsrichtung (5) des Substrats (1) versetzt sind.

12. Vorrichtung nach einem der Ansprüche 7 bis 11, **dadurch gekennzeichnet, daß** sie mindestens einen multizellulären Kreis (2) umfaßt, der im wesentlichen aus einer Gruppe von separaten identischen Magnetkreisen (2', 2", 2''') von relativ geringen Abmessungen besteht, welche gegeneinander in aufeinanderfolgenden Reihen (12', 12", 12''') quer zu der Bewegungsrichtung (5) des Substrats (1) angeordnet sind, wobei die Magnetkreise einer Reihe (12'') im Verhältnis zu denen der benachbarten Reihen (12', 12"') versetzt sind.

13. Vorrichtung nach einem der Ansprüche 7 bis 12, **dadurch gekennzeichnet, daß** das Substrat (1) sich an der zylindrischen Oberfläche (14) mindestens einer Trommel (15, 16, 17), die um ihre Achse (18) drehbar montiert ist, abstützt, wobei mindestens ein Magnetkreis (2) im Innern der Trommel gegenüber der Stelle angeordnet ist, wo das Substrat (1) in Kontakt mit der Trommel (15, 16, 17) kommt.

14. Vorrichtung nach Anspruch 13, **dadurch gekennzeichnet, daß** sie mindestens zwei in der Bewegungsrichtung (5) des Substrats (1) aufeinanderfolgende Trommeln (15, 16, 17) umfaßt, mit parallelen Achsen (18), die sich senkrecht zu dieser Richtung erstrecken, wobei sich das Substrat auf den Trommeln bewegt und in jeder derselben mindestens ein Magnetkreis (2a, 2b, 2c, 2d, 2e) angeordnet ist.

15. Vorrichtung nach Anspruch 13 oder 14, **dadurch gekennzeichnet, daß** sie zu belden Seiten der Trommel (15, 16, 17) eine Umlenkrolle (9) für das Substrat (1) mit zu der Achse der Trommel paralleler Achse umfaßt, derart, daß eine möglichst große Kontaktoberfläche (19) zwischen der Trommel und dem Substrat (1) erhalten wird.

16. Vorrichtung nach Anspruch 14 oder 15, **dadurch gekennzeichnet, daß** der oder die Magnetkreise (2a), die in einer der Trommeln (15) angeordnet sind, im Verhältnis zu demjenigen oder denjenigen, die in der anderen Trommel (16, 17) angeordnet sind, versetzt sind, derart, daß die Gesamtheit dieser Kreise im wesentlichen die gesamte Breite des Substrats (1) überdeckt.

17. Vorrichtung nach Anspruch 16, **dadurch gekennzeichnet, daß** eine der Trommeln (15) einen festen zentralen Magnetkreis (2a) umfaßt, dessen Abmessung längs der Richtung der Achse der Trommel höchstens gleich groß ist wie die minimale Breite der zu ätzenden Oberfläche des Substrats (1), wobei die andere Trommel (16) in der Nähe jeder ihrer Enden einen multizellulären Kreis (2b, 2c) umfaßt, der fest oder längs der Richtung der Achse (18) dieser anderen Trommel (16) in Abhängigkeit von der Breite der zu ätzenden Oberfläche beweglich ist.

18. Vorrichtung nach einem der Ansprüche 7 bis 17, **dadurch gekennzeichnet, daß** der Magnetkreis (2) um eine Achse (23), die sich quer zu der Ebene erstreckt, längs welcher das Substrat (1) sich bezüglich dieses Kreises bewegen kann, drehbar montiert ist.

## Claims

1. A continuous process for pickling at least one of the sides of a substrate (1) having a variable width, formed preferably by a continuous metallic strip, such as a steel sheet, according to which this substrate (1) is moved according to a predetermined direction between an anode (8), with respect to which it is polarised negatively, and at least one magnetic circuit (2) disposed opposite this anode (8), the side to be pickled being directed towards the anode (8), and, in the proximity of this side, a plasma (10) is created in a gas so as to generate radicals and/or ions acting thereon, **characterized in that** use is made of means enabling to adjust the width of the field of action of the magnetic circuit to the width of the zone of the substrate (1) which is to be pickled, i.e. transversally to the travelling direction (5) thereof.

2. A process according to claim 1, **characterized in that** use is made of at least two different independent magnetic circuits (2a, 2b, 2c, 2d, 2e) which are insulated from one another and which form a whole extending transversally with respect to the travelling direction (5) of the substrate (1), over the entire width of the aforementioned zone which is to be pickled.

3. A process according to claim 1 or 2, **characterised in that** use is made of a multicellular circuit (2) comprising a succession of magnetic circuits (2', 2", 2"') of relatively reduced dimensions and extending against one another in successive rows (12', 12", 12"') transversally to the travelling direction (5) of the substrate (1).

4. A process according any one of the claims 1 to 3, **characterized in that** use is made of at least one magnetic circuit (2b, 2c, 2d, 2e) having dimensions, in the direction transverse to the travelling direction of the substrate, which are adjustable in function of the width of the zone of the substrate (1) which is to be pickled.

5. A process according to any one of the claims 2 to 4, **characterised in that** use is made of magnetic circuits (2) which extend according to at least two transverse rows (12', 12", 12"') with respect to the travelling direction (5) of the substrate (1), care being taken that the circuits of one of the rows (12") overlap with those of the other rows (12', 12''') when considering the travelling direction (5) of the substrate (1).

6. A process according to claim 5, **characterized in that** use is made of identical grouped magnetic circuits (2', 2", 2"') which are disposed one against the other in successive rows (12', 12", 12"') according to the travelling direction (5) of the substrate (1) and in a regular bond in such a manner that a magnetic circuit from one row (12") is shifted by half with respect to the successive magnetic circuits of an adjacent row (12', 12"') of magnetic circuits (2', 2", 2"').

7. A device for pickling at least one of the sides of a substrate (1), having a variable width, in particular of a continuous metallic strip, such as a steel sheet, comprising means for moving this substrate (1) according to a predetermined direction (5) between an anode (8) and at least one magnetic circuit (2) disposed opposite this anode (8), the side to be pickled being directed towards the anode (8), means being also provided, on the one hand, for polarising the substrate negatively with respect to the anode (8) when passing in front of this anode, and, on the other hand, for creating between the anode (8) and the side which is to be pickled a plasma (10) in a gas so as to generate radicals and/or ions which can act thereon, **characterized in that** other means are provided enabling to adjust the width of the field of action of this magnetic circuit automatically to the width of the zone of the substrate (1) which is to be pickled, i.e. transversally to the travelling direction (5) thereof.

8. A device according to claim 7, **characterised in that** said other means enabling to adjust the width of the field of action of the magnetic circuit comprise at least two different independent magnetic circuits (2a, 2b, 2c, 2d, 2e) which are insulated from one another and which form a whole extending transversally with respect to the travelling direction (5) of the substrate (1), over the entire width of the aforementioned zone which is to be pickled.

9. A device according to claim 8, **characterised in that** each magnetic circuit (2) comprises a central south pole (4) surrounded, at a certain distance, by a north pole (3), or vice versa, these poles (3, 4) being directed towards the substrate.

10. A device according to claim 8 or 9, **characterised in that** it comprises at least one magnetic circuit (2), the dimensions of which in the direction transverse to the travelling direction (5) of the substrate (1) are adjustable in function of the width of the zone to be pickled thereof.

11. A device according to any one of the claims 8 to 10, **characterised in that** it comprises a central magnetic circuit (2a) which is variable or not and movable or variable magnetic circuits (2b, 2c, 2d, 2e) according to a direction (7) transverse to the travelling direction (5) of the substrate (1), these lateral magnetic circuits (2b, 2c, 2d, 2e) being shifted with respect to the central magnetic circuit (2a) in the travelling direction (5) of the substrate (1).

12. A device according to any one of the claims 7 to 11, **characterised in that** it comprises at least one multicellular circuit (2) composed essentially of a whole of separated identical magnetic circuits (2', 2", 2"') having relatively reduced dimensions and being situated against one another in successive rows (12', 12", 12"') transversally to the travelling direction (5) of the substrate (1), the magnetic circuits of one row (12") being shifted with respect to those of the adjacent rows (12', 12'").

13. A device according to any one of the claims 7 to 12, **characterised in that** the substrate (1) rests on a cylindrical surface (14) of at least one drum (15, 16, 17) rotatably mounted around its axis (18), at least one magnetic circuit (2) being arranged within the drum opposite the location where the substrate (1) comes into contact with the drum (15, 16, 17).

14. A device according to claim 13, **characterised in that** it comprises at least two successive drums (15, 16, 17), in the travelling direction (5) of the substrate (1), having parallel axes (18) extending perpendicularly to this direction, over which drums the substrate travels and in each of which is arranged at least one magnetic circuit (2a, 2b, 2c, 2d, 2e).

15. A device according to claim 13 or 14, **characterised in that** it comprises on both sides of the drum (15, 16, 17) a return roller (9) for the substrate (1), having an axis parallel to the one of the drum, in order to obtain a contact surface (19) between this drum and the substrate (1) which is as large as possible.

16. A device according to claim 14 or 15, **characterised in that** the magnetic circuit or circuits (2a) arranged in one of the drums (15) are shifted with respect to that or those arranged in the other drum (16, 17), in such a manner that the whole of these circuits covers substantially the entire width of the substrate (1).

17. A device according to claim 16, **characterised in that** one of the drums (15) comprises a fixed central magnetic circuit (2a), the dimension of which according to the direction of the drum axis is at the most equal to the minimum width of the surface to be pickled of the substrate (1), the other drum (16) comprising, in the proximity of each of its extremities, a multicellular circuit (2b, 2c) which is fixed or movable according to the direction of the axis (18) of this other drum (16) in function of the width of the surface to be pickled.

18. A device according to any one of the claims 7 to 17, **characterised in that** the magnetic circuit (2) is rotatably mounted around an axis (23) extending transversally to the plane according to which the substrate (1) can move opposite this circuit.
